Europäisches Patentamt

European Patent Office

Office européen des brevets

(11) Publication number: **0 225 973**
**A2**

## (12) EUROPEAN PATENT APPLICATION

(21) Application number: 86112144.0

(22) Date of filing: 02.09.86

(51) Int. Cl.4 **G01R 33/028**

(30) Priority: 01.11.85 US 794154

(43) Date of publication of application:
24.06.87 Bulletin 87/26

(84) Designated Contracting States:
DE FR GB

(71) Applicant: Hewlett-Packard Company
Mail Stop 20 B-O 3000 Hanover Street
Palo Alto California 94304(US)

(72) Inventor: Terrien, Mark
3671 Hemlock Street
Santa Rosa, CA 95401(US)
Inventor: Linkwitz, Siegfried
2150 Hyland Court
Santa Rosa, CA 95404(US)

(74) Representative: Liesegang, Roland, Dr.-Ing.
Sckellstrasse 1
D-8000 München 80(DE)

(54) **Electromagnetic field probe.**

(57) A hand-held electromagnetic field probe, which is sensitive only to magnetic fields and rejecting electric field coupling, comprises two unshielded single turn loops (11,12) with opposed windings, which produce electrically coupled output voltages that are in phase and magnetically induced output voltages that are 180 degrees out of phase. The phase of the signal from one loop is reversed and then the signals are summed so that the electric field components cancel and the magnetic field components add to each other.

FIG 1

EP 0 225 973 A2

## Electromagnetic field probe

Background and Summary of the Invention

This invention relates generally to probes for detecting electromagnetic fields and in particular to a hand-held electromagnetic field probe designed to be sensitive to magnetic fields only, specifically rejecting electric field coupling.

Every electromagnetic device emits electric and magnetic fields in a ratio that depends upon the nature of the source. There fields couple to objects around them and generate electrically coupled (Ve) and magnetically induced (Vh) voltages. The magnitudes of these voltages coupled to a measurement probe are a function of the probe geometry.

Loop antennas of some sort have been used by engineers as diagnostic tools for some time. They are usually made from one or more turns of insulated wire connected directly through a length of coaxial cable to a measurement device. Although they are simple to build, it is ordinarily difficult to obtain repeatable results from such loops since they respond to both electric and magnetic fields. The electric field coupling depends on a wide range of factors and is complicated by reflections from the walls of the enclosure where the measurement is made, and field coupling to the connecting cable for the loop. For example, capacitive coupling can result in a variation of up to 30-40 dB in the measurement electric field depending on the geometry of the test set up. If it is desired to measure magnetic fields alone, some method must be used to attenuate electric field (E-field) response.

The simplest way to reduce E-field response it to make the loop very small. The sensitivity of a loop to electric fields decreases faster than magnetic field sensitivity with decreasing loop size. Small loops may also have better spatial resolution than large loops, an attribute that is valuable when characterizing the shape of magnetic fields. However, minimum loop size is limited by the sensitivity required and by fabrication constraints.

Another approach uses a selective shield on the loop to attenuate only E-fields. The loop is made typically from coaxial cable, with an inside conductor surrounded by an outside conductor or shield the electric field. The shield is broken at one point around the loop to prevent shield current flow induced into the shield by the incident magnetic field so that magnetic fields can induce voltages on the inside conductor loop. However, such loops are difficult to fabricate, their bulkiness makes it awkward to measure fields in small openings or near the seams of device enclosures, and their relatively large size decreases spatial resolution.

It is an object of the invention to provide a hand-held probe sensitive only to magnetic fields, using two unshielded loops and cancelling the electrically coupled voltages Ve leaving only the magnetically induced voltages Vh.

It is also an object of the invention to provide a hand-held magnetic field probe that is simple and inexpensive to manufacture, with a loop that can be fabricated on a multi-level printed circuit board to ensure a rugged, stable loop geometry of closely controlled dimensions.

These and other objects are solved by the features of claim 1.

In accordance with the invention, the preferred embodiment provides a probe with two unshielded single turn loops with opposed windings that maintain symmetrical positioning relative to each other. The opposed windings result in magnetically induced output voltages (Vh) that are 180 degrees out of phase. The symmetrical positioning results in electrically coupled output voltages (Ve) that are in phase. Indentical loop geometry keeps the coupled voltage magnitudes the same at each loop.

The signals from the two loops are subtracted from one another by reversing the phase of one of the signals and then summing the signals.

Because of the phase reversal, when the signals is reversed and the signals are summed, the components of Ve cancel out leaving an output voltage of 2 Vh. The output voltage of the probe is then directly proportional to the magnetic flux at the loops and dependent upon the frequency and the loop area. The probe can be calibrated with a known magnetic field source.

Detailed Description of the Drawings

Figure 1 is an idealized schematic of a probe constructed in accordance with the invention.

Figure 2 is an isometric view of the antenna loop section of the preferred embodiment of the invention.

Figure 3 shows a cross-sectional view of the microstrip transmission lines of Figure 1.

Figure 4 is a schematic plan view of the balun section of the preferred embodiment of the invention.

## Detailed Description of the Preferred Embodiment

The probe is comprised of two unshielded loops which receive the electromagnetic signals, microstrip transmission lines to convey the signals, and a balun section which reverses the phase of the signal from one loop and sums the signals from the loops and an output line which can be connected to a measurement instrument. Because the loops are unshielded and microstrip lines are used to transmit the signals, the entire probe can be fabricated on a multilayer.

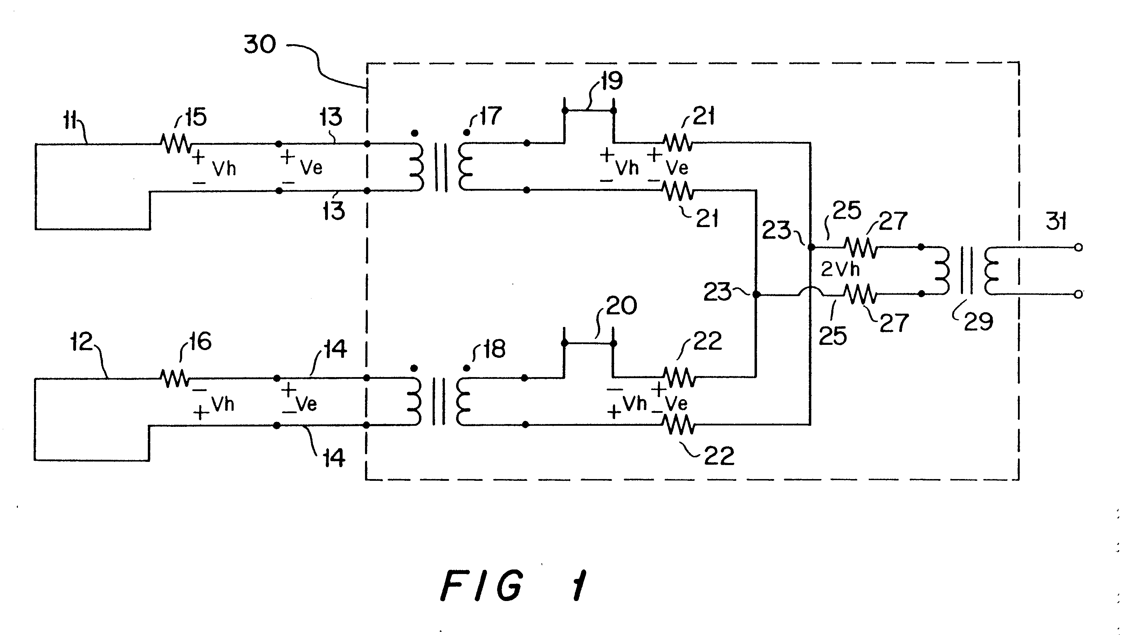

The two loops, 11 and 12, have effectively opposite winding directions and are connected through 50 ohm matching resistors 15 and 16 to microstrip transmission lines 13 and 14. The opposed windings of the loops result in magnetically induced output voltages Vh that are 180 degrees out of phase as indicated on Figure 1. The loops are symmetrically positioned relative to each other so that the electrically coupled output voltages Ve that are induced are in phase as indicated in Figure 1. The loops thus produce two balanced signals with Ve in phase and Vh out of phase. Microstrip lines 13 and 14 are balanced transmission lines and the 50 ohm matching resistors match the impedance of the loops to the 50 ohm impedance of the microstrip lines. The two microstrip transmission lines, 13 and 14, are sufficiently separated to keep the forward and reverse coupling between the lines greater than 40 db.

The other ends of the two microstrip transmission lines are connected to balun section 30. At the connection point, the signals from the loops are coupled by transformers 17 and 18. This effectively prevents any common mode currents generated at the summing point 23 in balun section 30 from being transmitted back to the loops and interfering with the external electromagnetic field signals received by the loops. Transformers 17 and 18 also preserve the phase relationship of the signals from the loops.

The signals next pass through phase-matching structures 19 and 20. These structures comprise variable length microstrip transmission lines which can be adjusted in order to compensate for any differences in electrical path lengths in the transmission lines from the loops. By properly adjusting the phase matching structures when the probe is calibrated during assembly, the differential phase shift between the loops can be manually set to equal exactly 180 degrees. This adjustment eases the assembly procedure by lowering the need to control the tolerances of the electrical path lengths band of the materials used in transformers 17 and 18.

The two phase adjusted signals are then applied to summing junction 23 and an effective 180 degree phase shift is achieved by cross connecting the positive and negative leads of the transmission lines. Because the phase of the electrically coupled voltages were originally the same, the phase shift results in cancelling the electrical voltage from loop 1 and loop 2. In contrast, because the magnetically induced voltages were 180 degrees out of phase, the reversal results in constructive interference and a doubling of the magnetic signal. As indicated in Figure 1, the output on microstrip lines 25 from summing junction 23 is 2 Vh.

A proper impedance match between the loops and the signal junction point is required to maintain the relative phasing between the two signals. Impedance mismatches would create standing waves along each transmission line and would result in unequal signal phase shifts. Significant mismatches would create phase shifts that could not be compensated for by the phase matching structure. The impedance of each signal line is matched to the summing junction impedance by resistors 21 and 22. The impedance on the output line from the summing junction is matched by resistors 27. It is important to note that the matching impedance is split between the two conductors of the transmission lines rather than placed entirely in one conductor of the transmission line as is the standard practice. This is necessary to provide good matching even though the phase of one line has been reversed at the summing junction. Splitting the resistance evenly between two conductors results in better low-frequency impedance matches on the two input lines and the output line from summing junction 23.

The output signals on line 25 are isolated by transformer 29 to further improve common mode rejection after the signal junction point. The signals are then output via terminal 31. The output terminals are typically connected through an unbalanced coaxial cable to an instrument making the measurement of the electromagnetic field. For example, either a receiver or a spectrum analyzer.

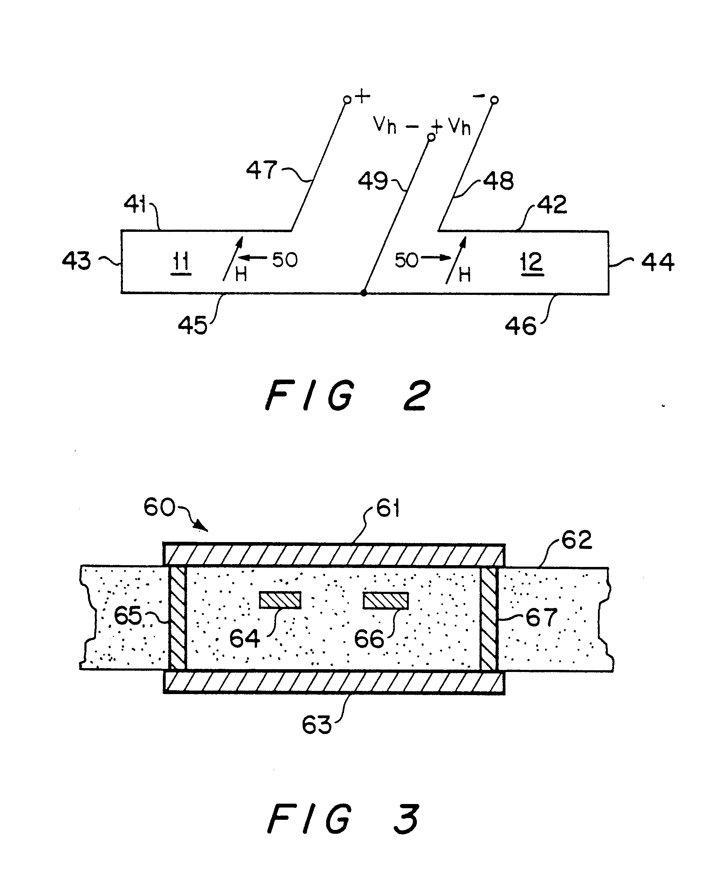

Some details of the construction of the loops 11 and 12 are shown in Figure 2, which is an isometric end-on view of the two loops. The left loop, 11, is comprised of a top line 41, a side line 43, and a bottom line 45. This geometry can be conveniently implemented on a printed circuit board with top line 41 on the top surface of the printed circuit board, side 43 being a plated through hole in the board and bottom line 45 being on the bottom circuit surface of the printed circuit board. Likewise, loop 12 comprises a top line 42, said line 44 and bottom line 46. The dimensional tolerance and stability of the printed circuit board material and the inherent ruggedness of this construction enhance the probe's durability and uniformity of sensitivity. Top line 41 of loop 11 is connected to transmission line 47 on the top surface of the printed circuit board and bottom line 45 of loop 11 is connected to common transmission line 49. In loop 12 top line 42 is connected to transmission line 48 and bottom line 46 is connected to common transmission line line 49. For a magnetic field normal to the page as indicated by arrow 50 in Figure 2, the magnetically induced voltages are as shown on output lines 47, 48 and 49 with loop 11 producing positive voltage on line 47 and negative voltage on line 49 while loop 12 produces positive voltage on line 49 and negative voltage on line 48. Output lines 47 and 48 are connected through impedance matching resistors 15 and 16 into microstrip lines 13 and 14. Common output line 49 is also connected into the reference plane of the microstrip transmission lines.

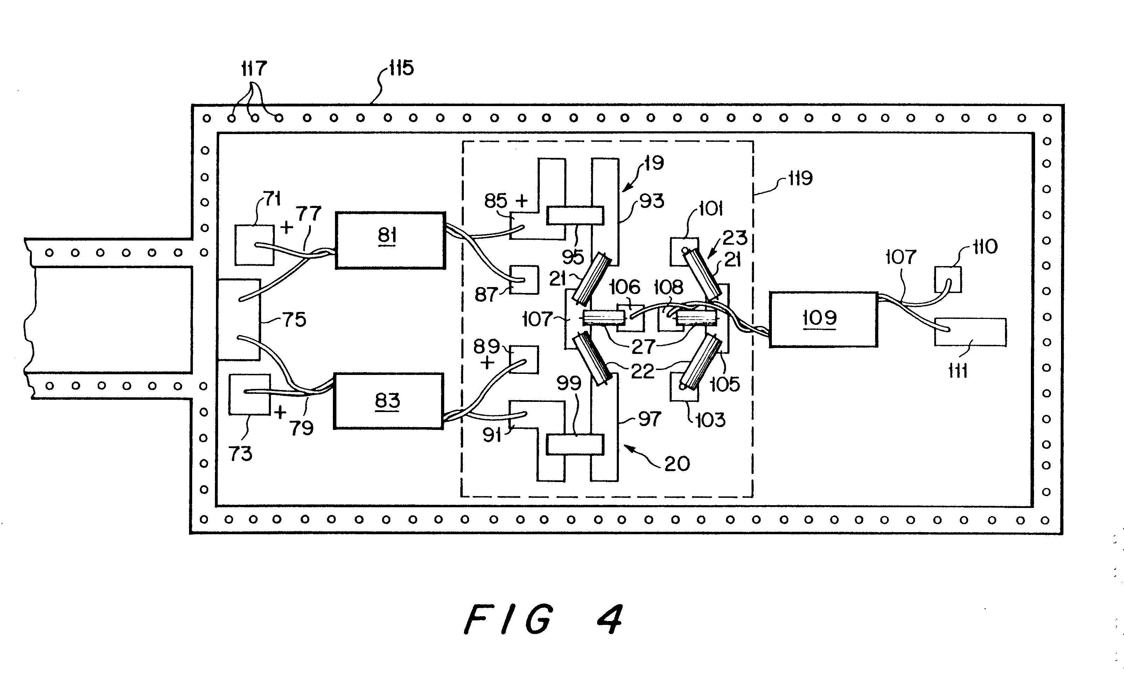

Figure 3 shows a cross-sectional view of the microstrip transmission lines 13 and 14 and their shielding enclosure 60. As with loops 11 and 12, the construction of these lines is suitable for implementation on a multi-layer PC board. Transmission lines 64 and 66 are plated on middle levels of the multi-layer PC board 62 and are enclosed by a shielding box. The box comprises a top layer of metalization 61 and a bottom layer of metalization 63. These two layers are connected by rows of plated-through holes 65 and 67 which are closely spaced along the length of transmission line 64 and 66 in order to shield the transmission lines from electromagnetic radiation. In the illustration of Figure 3, the thicknesses of metallic layers 61 and 63 are out-of-scale for the sake of clarity. The two microstrip transmission lines 64 and 66 provide for an efficient balanced transmission of the signals from loop 11 and loop 12. Line 64 is connected through impedance matching resistor 15 to output line 47 of loop 11. Line 66 is connected through impedance matching resistor 16 to line 48 of loop 12. Common return line 49 from the two loops is connected to the reference plane 63. The output end of the microstrip lines is connected to the balun section 30 which is shown in Figure 4.

Figure 4 shows the balun section of the probe. In Figure 4 the components of the balun secton are shown in schematic plan view. At the left side of Figure 4, the input lines from microstrip transmission lines 13 and 14 are terminated on pads 71, 72 and 75. The signals from loop 11 are carried by twin line 77 to phase matching structure 19 and into summing junction 23. The signals from loop 12 are carried by twin line 79 to phase matching structure 20 and into summung junction 23. The resulting summed signal from junction 23 are carried by twin line 107 to output terminals 110 and 111. The signals from loop 11 are connected across pads 71 and 75, and the signals from loop 12 are connected across pads 73 and 75, with pad 71 connected to transmisson line 64, pad 73 connected to transmission line 66 and pad 75 connected to common reference line 63. From the pads the signals are transmitted through twin lines 77 and 79. The twin lines are threaded several times through two ferrite cylinders 81 and 83 to effectively increase the common mode impedence along the twin lines and isolates the common mode signals generated at the summing junction from the transmission lines to the loops. Twin line 77 from loop 11 is terminated at pad 87 and at one leg 85 of phase matching structure 19. The positive line from pad 71 is connected to the phase matching structure 85 while the negative line from common line 75 is connected to pad 87. Twin line 79 from loop 12 is also connected to a pad 89 and one side of a phase matching structure 20. However, the connections for line 79 are reversed with the positive line from pad 73 being connected to pad 89 while the negative line from pad 75 is connected to the phase matching strucure 20.

This reversal causes a 180 degree phase shift of the signals applied to summing junction 23. Phase matching structure 19 includes a second leg 93 and a bridge 95 which can be manually placed at the proper position between leg 85 and leg 93 to change the path length through the circuit in order to ensure proper phasing. Similarily, phase matching structure 20 includes a second leg 97 and an adjustable bridge 99.

Following the signals from loop 11 through the network, pad 87 is connected via a ground plane - (unshown) to pad 101 and then through impedance matching resistor 21 into one side of the summing junction at pad 105. The other line from loop 11 is connected through phase matching structure 19 then through impedance matching resistor 21 into the other side of the summing junction at pad 107. The signals from Figure 12 are similarily coupled to summing junction 23 with the positive side from pad 89 routed through the ground plane to pad 103 and then through matching resistor 22 to pad 105 at one side of the summing junction. The signal from phase matching network 20 passes through impedance matching resistor 22 to the other side of the summing junction at pad 107. The summed output signals are connected through impedance matching resistors 27 to pads 106 and 108. There they are connected to twin line 107 which is threaded several times through ferrite cylinder 109 and then connected to output pads 110 and 111. Threading output twin line 107 through ferrite core 109 effectively increases the common mode impedance along this twin line and isolates the balun section from the signals on the connecting cable between the probe and the measurement instrument.

Surrounding the balun section is a metalized border 115 which is connected to a metalized ground plane not shown underneath the entire balun section by plated through holes 117. The shielding of the balun section is completed by a metal cover (not shown) which is attached to the perimeter of metal border 115 and covers the top of the balun section.

The summing junction 23 and phase adjusting structures 19 and 20 are further shielded by a metalization layer 119 shown in dotted lines. Layer 19 lies between the summing junction at the top level of the PC board and the ground plane on the bottom level of the PC board.

The PC board holding the probe, loops, transmission line and balun section is held in a molded plastic case. The narrow loops 11 and 12 protrude from one end of the case so that they can be placed adjacent to any desired location to be tested. The output of the probe from output pads 110 and 111 may be connected through a suitable coaxial cable connector at the opposite end of the plastic case.

## Claims

1. A hand held electromagnetic field probe sensitive only to magnetic fields and rejecting electric field coupling so that the output signal from the probe is a function of the incident magnetic field, **charactericed** by

two symmetrical unshielded antenna loops (11,12) with opposed windings, producing balanced output signals having electric field components that are in phase and magnetic field components that are substantially 180 degrees out of phase; and

a balun section (30) capable of receiving the output signals of the antenna loops (11,12) and having means for reversing the phase of the signal from one of the loops and then summing the signals so that the electric field components cancel and the magnetic field components add together to produce an output signal on an unbalanced output line.

2. The probe of claim 1, **characterized** by

shielded microstrip transmission lines (13,14) for providing balanced transmission of the output signals from the antenna loops (11,12) to the balun section (30);

impedance matching resistors (15,16) connected between the microstrip transmission lines (13,14) and the antenna loops (30).

3. The probe of claim 1 or 2, **characterized** in that the balun section (30) comprises:

phase matching structures (19,20) with manually adjustable path lengths to compensate for variations in the signal transmission lines of the probe;

means (17,18) for providing a high impedance to common mode signals while providing a constant impedance matched to the impedance of the microstrip lines for differential mode signals between the antenna loops (11,12) and the balun section (30);

a summing junction (23) for combining the two balanced signals from the antenna loops (11,12) to produce an output signal on an unbalanced output line, having impedance matching resistors - (21,22,27) on both conductors of the transmission lines from the antenna loops and on both conductors of the output line; and

means (29) for providing the high impedance to common mode signals while providing a constant impedance for differential mode signals on the output line.

FIG 1

*FIG 2*

*FIG 3*

FIG 4

0 225 973